# EUROPEAN PATENT SPECIFICATION

(11) **EP 4 667 786 B1**
(45) Date of publication and mention of the grant of the patent: **22.07.2026**
(21) Application number: 25170806.1
(22) Date of filing: 15.04.2025
(51) Int. Cl.: F16H 61/00, H04L 12/40

(54) **PRINTED CIRCUIT BOARD**
GEDRUCKTE SCHALTUNGSPLATTE
CARTE DE CIRCUIT IMPRIMÉ

(30) Priority: 18.06.2024 GB 202408723
(43) Date of publication of application: 24.12.2025
(73) Proprietor: Oxa Autonomy Ltd, Oxford OX4 2HW (GB)
(72) Inventor: ALI, Mian, Oxford OX4 2HW (GB); STEWART, Alex, Oxford OX4 2HW (GB); BOYD, Amy, Oxford OX4 2HW (GB); AUSTIN, Matthew, Oxford OX4 2HW (GB); ALLOT, Andrew, Oxford OX4 2HW (GB)
(74) Representative: Appleyard Lees IP LLP

(56) References cited:
- DE-A1- 102022 113 333
- US-A1- 2012 005 393
- US-A1- 2020 231 168
- US-A1- 2024 119 536

## Description

### FIELD

The subject-matter of the engaged invention relates to a printed circuit board.

### BACKGROUND

Autonomous vehicles may operate in both autonomous and non-autonomous driving modes. When in an autonomous driving mode, an autonomy stack modifies, or replaces, signals between a controller area network, CAN, bus and a gear shift module, GSM. When in a non-autonomous driving mode, the autonomy stack is disengaged and so the CAN bus signals are transmitted directly to the GSM without being modified or replaced by the autonomy stack.

It is an aim of the present invention to address such problems and improve on the prior art.

US2024119536 discloses methods and apparatus for controlling a vehicle based on motion or kinematic data received by a computer when the behavior of a driver is being monitored. Such methods and apparatus may generate one or more safety indices that may include a driver score, a vehicle safety score, and/or an environment safety score. These safety indices may optionally be weighted and combined into an overall safety score, grade, or index. The safety scores or indices may be used to generate a personalized speed threshold or acceleration threshold for a vehicle and/or a driver of the vehicle. Methods and apparatus consistent with the present disclosure may result in the speed of a vehicle being reduced, an increase in vehicle location accuracy, or functions such as headlights or windshield wipers or automated driving assistance being turned on to increase safety.

US2020231168 describes techniques for an interface board for harmonizing performance of different autonomous vehicles in a fleet. The interface system includes a printed circuit board installed in a host vehicle that includes an interface controller and interface circuitry coupled to the interface controller. The interface circuitry includes a plurality of relays configured by the interface controller to route/pass sensor signals received from actuators of the host vehicle to the interface controller, and route/pass control signals from the interface controller to actuator controllers of the host vehicle that control the actuators in accordance with an operating mode. Signal conditioning circuitry in the interface controller conditions the sensor signals and control signals to ensure that the electrical characteristics of the sensor signals are compatible with the interface controller, and that the electrical characteristics of the control signals are compatible with the actuator controllers.

US2012005393 describes an electrical and electronic system having a control unit connected to a remotely located electrical center by way of a data bus. The electrical center includes a bus interface unit and a main printed circuit board having a plurality of control devices such as relays, which selectively activate vehicle electrical circuits based on instructions from the control unit. The bus interface unit is that of a daughter board configured to be plugged into the main board of the electrical center, such as a Local Interconnect Network (LIN) interface board, and the data bus may be a LIN bus.

DE102022113333 describes an adaptation device for adapting at least one control unit designed for manual operation of a control process to automatic operation, with at least one input connection for an automatic input unit and at least one output connection for at least one control unit for the control process. The adaptation device is characterized in that it has at least one input connection for at least one manual input unit and in that the adaptation device has at least one emulation unit, which converts the input data received via the at least one input connection for the automatic input unit into input signals in the form of the at least one manual input unit and to the at least one output connection for the at least one control unit. This allows vehicles to be converted for automatic operation without having to make software changes to the control units.

### SUMMARY

According to an aspect of the invention, there is provided a printed circuit board comprising: a plurality of terminals for connecting to a controller area network, CAN, bus of a vehicle, a gear shift module, GSM, and an electronic control unit, ECU, the CAN bus configured to receive user control inputs from one or more control interfaces of the vehicle and to send gear selection control signals to gears of the vehicle, the GSM configured to select one gear of the gears based on the control inputs, the ECU configured to modify the gear selection control signals based on a control command from an autonomy stack; a stop terminal for connecting to a stop input; and a plurality of circuits configured to: connect the CAN bus to the ECU and the ECU to the GSM when the stop input is disengaged; and connect the CAN bus to the GSM and bypass the ECU when the stop input is engaged. Using switching integrated circuits in this way provides a hardware means of bypassing the ECU, and thus the autonomy stack, which is more reliable, cheaper, and simpler, than using software to bypass the ECU.

In an embodiment, the plurality of terminals comprise: a first CAN terminal for connecting to the CAN bus; a second CAN terminal for connecting to the GSM; a first ECU terminal for connecting to a first terminal of the ECU; and a second ECU terminal for connecting to a second terminal of the ECU.

In an embodiment, the plurality of circuits are configured to: connect the first CAN terminal with the first ECU terminal and to connect the second CAN terminal with the second ECU terminal when the stop input is disengaged; and connect the first CAN terminal with the second CAN terminal when the stop input is engaged.

In an embodiment, the plurality of circuits comprises a first switching integrated circuit, a second integrated circuit, wherein: when the stop input is disengaged, the first switching integrated circuit is configured to transfer a signal between the first CAN terminal and the first ECU terminal, and when the stop input is disengaged, the second switching integrated circuit is configured to transfer a signal between the second CAN terminal and the second ECU terminal.

In an embodiment, when the stop input is engaged, the first switching integrated circuit and the second switching integrated circuit are configured to transfer a signal between the first CAN terminal and the second CAN terminal.

In an embodiment, there printed circuit board further comprises a plurality of transducers configured to convert between analogue signals associated with the CAN bus, the GSM, and the ECU, and digital signals associated with the first and second integrated circuits.

In an embodiment, the plurality of transducers includes: a first transducer connected between the first CAN terminal and the first integrated circuit; a second transducer connected between the first integrated circuit and the first ECU terminal; a third transducer connected between the second CAN terminal and the second integrated circuit; and a fourth transducer connected between the second integrated circuit and the second ECU terminal.

In an embodiment, the printed circuit board further comprises: a first power supply circuit comprising a step-down converter to step down a voltage of a signal associated with the stop input to a voltage for powering the integrated circuits; and a second power supply circuit comprising one or more step-down converters to step down the voltage of the signal associated with the stop input to a voltage for switching the first and second switching integrated circuits.

In an embodiment, the printed circuit board further comprises a relay configured to switch between the first power support circuit and the second power supply circuit in response to the stop input being engaged.

According to an aspect of the present invention, there is provided a vehicle comprising: a printed circuit board according to any preceding aspect or embodiment; the stop input; the CAN; the GSM; the ECU; the autonomy stack; and the gears.

According to an aspect of the present invention, there is provided a method of managing a connection between and controller area network, CAN, bus and a gear shifting module, GSM, in a vehicle operable in an autonomous mode and a non-autonomous mode, the method comprising: providing the printed circuit board of any preceding aspect or embodiment; connecting the CAN bus to the ECU and the ECU to the GSM when the stop input is disengaged; modifying, by the ECU, the gear selection control signal from the CAN bus based on the control command from the autonomy stack; and connecting the CAN bus to the GSM and bypassing the ECU when the stop input is engaged.

### BRIEF DESCRIPTION OF DRAWINGS

The subject-matter of the invention is best described with reference to the accompanying figures, in which:
Figure 1 shows a vehicle, according to at least one embodiment;
Figure 2 shows a block diagram of a plurality of components of the vehicle operating in a non-autonomous driving mode, according to at least one embodiment;
Figure 3 shows a block diagram of a plurality of components of the vehicle operating in an autonomous driving mode, according to at least one embodiment;
Figure 4 shows a table showing some connections from the components from Figures 2 and 3 in each of the respective driving modes, according to at least one embodiment;
Figure 5 shows a table showing other connections from the components from Figures 2 and 3 in each of the respective driving modes, according to at least one embodiment;
Figure 6 shows block diagram illustrating a switching printed circuit board from Figure 3, according to at least one embodiment; and
Figure 7 shows a method of managing a connection between a controller area network, CAN, bus, and a gear shifting module, GSM, from Figure 3, according to at least one embodiment.

### DESCRIPTION OF EMBODIMENTS

The embodiments described herein may be embodied as sets of instructions stored as electronic data in one or more storage media. Specifically, the instructions may be provided on a transitory or non-transitory computer-readable media. When executed by the processor, the processor is configured to perform the various methods described in the following embodiments. In this way, the methods may be computer-implemented methods. In particular, the processor and a storage including the instructions may be incorporated into a vehicle. The vehicle may be an autonomous vehicle (AV).

Whilst the following embodiments provide specific illustrative examples, those illustrative examples should not be taken as limiting, and the scope of protection is defined by the claims. Features from specific embodiments may be used in combination with features from other embodiments without extending the subject-matter beyond the content of the engaged invention.

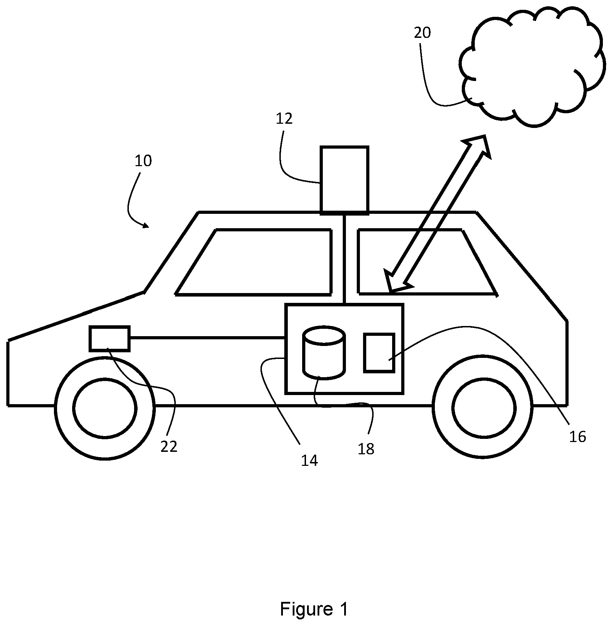

With reference to Figure 1, an AV 10 may include a plurality of sensors 12. The sensors 12 may be mounted on a roof of the AV 10, or integrated into the bumpers, grill, bodywork, etc. The sensors 12 may be communicatively connected to a computer 14. The computer 14 may be onboard the AV 10. The computer 14 may include a processor 16 and a memory 18. The memory may include the non-transitory computer-readable media described above. Alternatively, the non-transitory computer-readable media may be located remotely and may be communicatively linked to the computer 14 via the cloud 20. The computer 14 may be communicatively linked to one or more actuators 22 for control thereof to move the AV 10. The actuators may include, for example, a motor, a braking system, a power steering system, etc.

The sensors 12 may include various sensor types. Examples of sensor types include LiDAR sensors, RADAR sensors, and cameras. Each sensor type may be referred to as a sensor modality. Each sensor type may record data associated with the sensor modality. For example, the LiDAR sensor may record LiDAR modality data.

The data may capture various scenes that the AV 10 encounters. For example, a scene may be a visible scene around the AV 10 and may include roads, buildings, weather, objects (e.g. other vehicles, pedestrians, animals, etc.), etc.

An autonomy stack may be stored in the storage. The autonomy stack may generate a trajectory based on the sensor date. The autonomy stack may include an end-to-end model which is trained using input sensor data and corresponding output trajectories. The end-to-end model may be a neural network trained using back-propagation and an optimisation algorithm such as gradient descent. The trajectory may include control signals to control the actuators, or a separate control module may be configured to generate control commands based on the trajectory.

The autonomy stack may also include separate models each performing a function such as perception, planning, and control. The separate models may be learned models, or may be rules-based, or may be a combination of learned and rules-based models. The end-to-end model and the separate models may be used separately or in combination.

The vehicle may be operated in a normal driving mode or an autonomous driving mode.

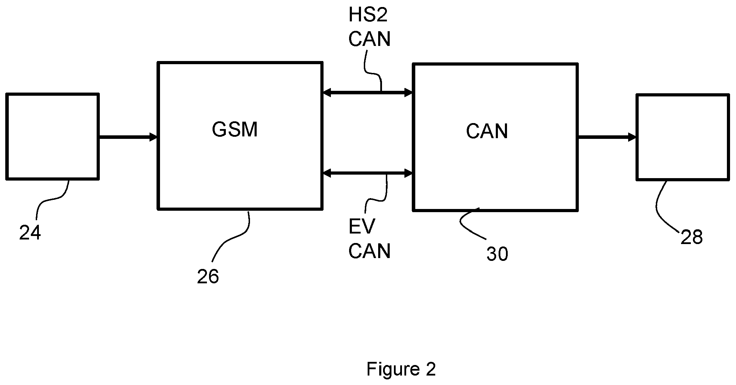

With reference to Figure 2, in the normal driving mode, a control input 24, e.g. a stick input signal, may be sent to a gear shift module, GSM, 26 of the vehicle. The GSM is configured to generate a gear selection control signal to select one gear of a plurality of gears 28 based on the control input. The GSM 26 may be connected to a controller area network, CAN, bus 30, of the vehicle which transfers the gear selection control signal to the gears 28.

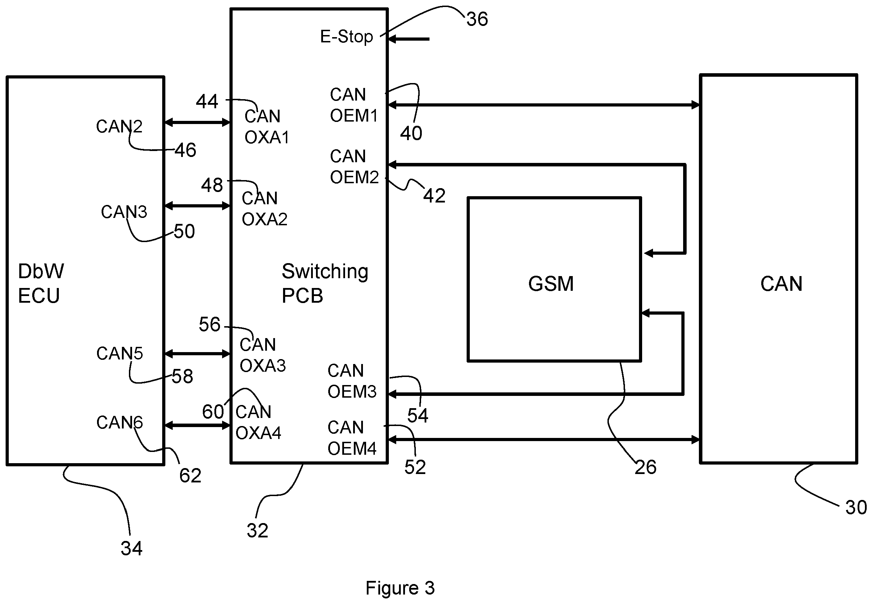

With reference to Figure 3, in the autonomous driving mode, the vehicle also includes a switching printed circuit board, PCB, 32, and a drive by wire electronic control unit, DbW ECU, 34. The DbW ECU may be called merely an ECU for ease of reference. The ECU may be associated with the autonomy stack. More particularly, the DbW ECU 34 is communicatively linked to the autonomy stack to receive control signals from the autonomy stack. The ECU 34 is communicatively positioned between the GSM 26 and the CAN bus 30. More specifically, the switching PCB 32 is positioned between the CAN and the GSM, and the ECU is connected to the switching PCB.

The switching PCB 32 comprises a plurality of terminals for connecting to the Can bus 30 of the vehicle, the GSM 26 of the vehicle and the ECU 34 of the vehicle. The CAN bus is configured to receive user control inputs from one or more control interfaces, e.g. the gear stick, of the vehicle, and is configured to send gear selection control signals to the gears of the vehicle. The ECU is configured to modify a gear selection control signal based on a control command generated by the autonomy stack. The switching PCB 32 also includes a stop terminal 36 for connecting to a stop input, a plurality of circuits configured to connect the CAN bus to the ECU and to connect the ECU to the GSM when the stop input is disengaged, and to connect the CAN bus to the GSM and to bypass the ECU when the stop input is engaged.

The plurality of terminals may comprise a first CAN terminal 40 for connecting to the CAN bus 30, a second CAN terminal 42 for connecting to the GSM 26, a first ECU terminal 44 for connecting to a first terminal 46 (CAN2) of the ECU 34, and a second ECU terminal 48 for connecting to a second terminal 50 (CAN3) of the ECU 34.

Similarly, the plurality of terminals may include a third CAN terminal 52 for connecting to the CAN bus 30, a fourth CAN terminal 54 for connecting to the GSM 26, a third ECU terminal 56 for connecting to a third terminal 58 (CAN5) of the ECU 34, and a fourth ECU terminal 60 for connecting to a fourth terminal 62 (CAN6) of the ECU 34.

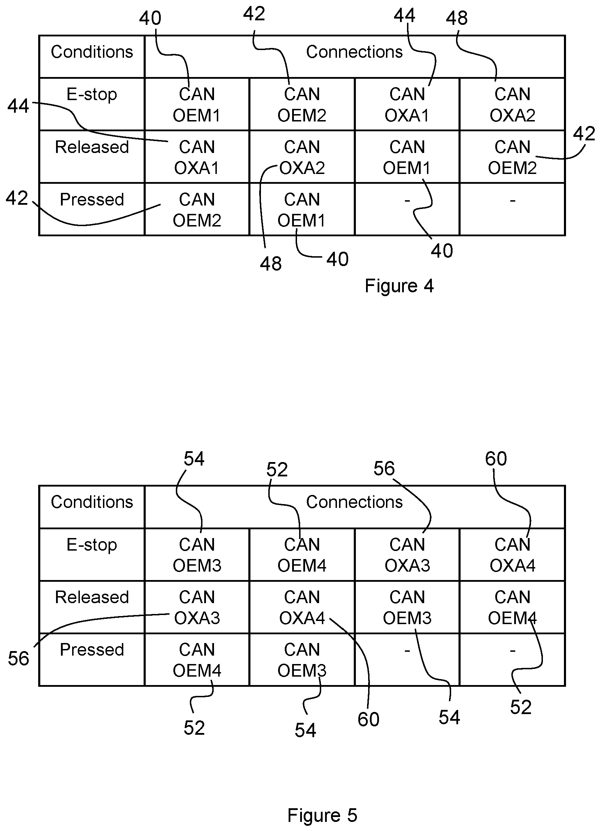

With reference to Figure 4, the plurality of circuits within the switching PCB 32 are configured to connect the first CAN terminal 40 (CAN OEM1) with the first ECU terminal 44 (CAN OXA1) and to connect the second CAN terminal 42 (CAN OEM2) with the second ECU terminal 48 (CAN OXA2), when the stop input is disengaged.

Similarly, the plurality of circuits within the switching PCB 32 are configured to connect the third CAN terminal 52 (CAN OEM4) with the third ECU terminal 56 (CAN OXS3) and to connect the fourth CAN terminal 54 (CAN OEM3) with the fourth ECU terminal 60 (CAN OXA4) when the stop input is disengaged.

The stop input may be a button within an interior of the vehicle, e.g. on the dash board. The stop input may be disengaged when the stop input is not pressed. When the stop input is pressed, the stop input may be said to be engaged.

With reference to Figure 5, when the stop input is engaged, the circuits may be configured to connect the first CAN terminal 40 with the second CAN terminal 42. Similarly, when the stop input is engaged, the circuits may be configured to connect the third CAN terminal 52 with the fourth CAN terminal 54.

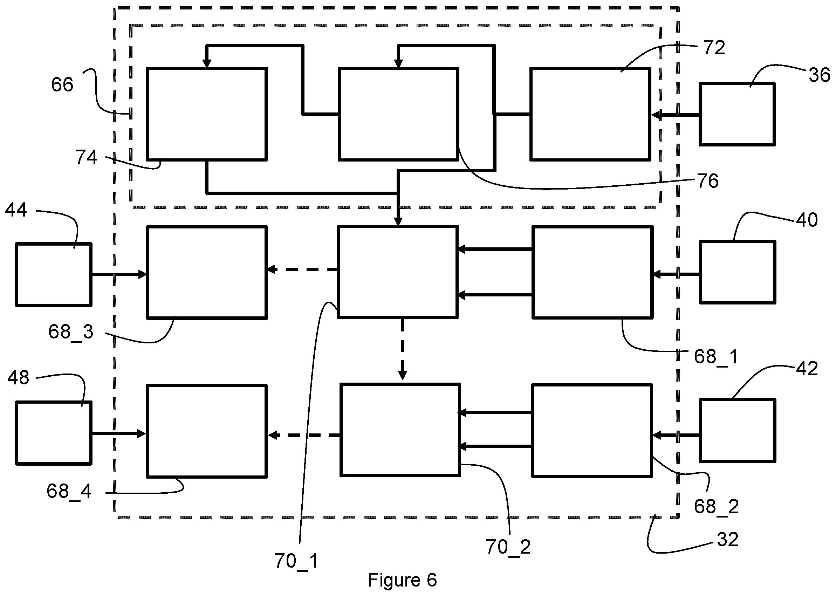

With reference to Figure 6, the switching PCB 32 includes a power circuit 66, a plurality of transceivers 68 and a plurality of switching integrated circuits 70.

The power circuit 66 includes a first power supply circuit 72, a second power supply circuit 74 and a relay 76. The first power supply circuit 72 has an input connected to the stop terminal 36. The first power supply circuit 72 comprises a step-down converter to step down a voltage of a signal associated with the stop input, e.g. 12 Volts, to a voltage for powering the integrated circuits, e.g. 5 Volts. In this embodiment, the stop input has a voltage of 12 Volts when the stop input is not pressed, or released, and has a voltage of 0 Volts when the stop input is pressed.

The second power supply circuit 74 includes two step-down converters. A first step down converter of the second power supply circuit 74 steps down the voltage from the voltage associated with the stop input, e.g. 12 Volts, to a voltage associated with powering the switching integrated circuits, e.g. 5 Volts. The second step-down converter of the second power supply circuit 74 steps down the voltage from the voltage associated with powering the switching integrated circuits, e.g. 5 Volts, to a voltage for switching the plurality of switching integrated circuits 70, e.g. 3.3 Volts. In this way, the second power supply circuit comprises one or more step-down converters to step down the voltage of the signal associated with the stop input to a voltage for switching the plurality of switching integrated circuits 70.

The relay 76 switches between power supplies. More specifically, when the stop input is released, the second power supply is active, or engaged, and the first power supply is not active. Conversely, when the stop input is pressed, the second power supply is inactive, or disengaged, and the first power supply is active. When the first power supply is active, 5V is supplied to the switching circuits 70. When the first power supply is not active, 0V is supplied to the switching circuits 70. When the second power supply is active 3.3V is supplied to switch the switching circuits and 5V is supplied to power the switching circuits. When the second power supply is not active, 0V is supplied to switch and power the switching circuits.

The plurality of transducers 68 includes a first transducer 68_1, a second transducer 68_2, a third transducer 68_3, and a fourth transducer 68_4. The plurality of switching integrated circuits 70 includes a first switching integrated circuit 70_1 and a second switching integrated circuit 70_2. The first transducer 68_1 connects the first CAN terminal 40 to the first switching integrated circuit 70_1. The second transducer 68_2 connects the second CAN terminal 42 to the second switching integrated circuit 70_2. The third transducer 68_3 connects the first switching integrated circuit 70_1 to the third CAN terminal 68_3. The fourth transducer 68_4 connects the second switching integrated circuit 70_2 to the fourth CAN terminal 68_4.

Each of the plurality of transducers are configured to convert between analogue and digital signals. The signals of the first and second CAN terminals 40, 42, and the first and second ECU terminals 44, 48, are analogue signals. The signals required by the switching integrated circuits are digital signals. Therefore, the first and second transducers 68_1, 68_2, are analogue to digital converters. The third and fourth transducers 68_3, 68_4, are digital to analogue converters. In this way, the plurality of transducers 68 are configured to convert between analogue signals associated with the CAN bus 30, the GSM 26, and the ECU 34 (Figure 3), and digital signals associated with the first and second integrated circuits 70_1, 70_2.

When the stop input is engaged, the first switching integrated circuit 70_1 and the second switching integrated circuit 70_2 are configured to transfer a signal between the first CAN terminal and the second CAN terminal. This happens because, when the stop input is engaged, pressed, or active, the first power supply circuit 72 supplies the 5 Volts for powering the switching integrated circuits but the 3.3 Volts for switching the switching integrated circuits is not supplied from the second power supply circuit 74. Therefore, the switching integrated circuits are not active and the first switching integrated circuit 70_1 supplies the signal to the second switching integrated circuit 70_2. In this way, the first CAN terminal 40 and the second CAN terminal 42 are connected.

When the stop input is disengaged, the first switching integrated circuit 70_1 and the second switching integrated circuit 70_2 are configured to transfer the signal between the first CAN terminal and the first ECU terminal 44, and to transfer the signal between the second CAN terminal 42 and the second ECU terminal 48, respectively. This happens because, when the stop input is disengaged, released, or inactive, the first power supply circuit 72 does not supply the 5 Volts for powering the switching integrated circuits and instead the 5 Volts for powering the integrated circuits and the 3.3 Volts for switching the integrated circuits are supplied by the second power supply circuit 74. In this way, when the stop input is disengaged, the first switching integrated circuit 70_1 is configured to transfer a signal between the first CAN terminal 40 and the first ECU terminal 44 and, when the stop input is disengaged, the second switching integrated circuit 70_2 is configured to transfer a signal between the second CAN terminal 42 and the second ECU terminal 48.

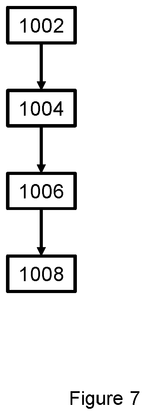

With reference to Figure 7, a method of managing a connection between a controller area network, CAN, bus and a gear shifting module, GSM, in a vehicle operable in an autonomous mode and a non-autonomous mode, may be summarised as comprising: providing 1002 the switching PCB 32; connecting 1004 the CAN bus 30 to the ECU 34 and the ECU 34 to the GSM 26 when the stop input is disengaged, or not pressed; modifying 1006, by the ECU 34, the gear selection control signal from the CAN bus 30 based on the control command from the autonomy stack; and connecting 1008 the CAN bus 30 to the GSM 26 and bypassing the ECU 34 when the stop input is

## Claims

1. A printed circuit board (32) comprising:
a plurality of terminals for connecting to a controller area network, CAN, bus (30) of a vehicle, a gear shift module, GSM (26), and an electronic control unit, ECU (34), the CAN bus (30) configured to receive user control inputs from one or more control interfaces of the vehicle and to send gear selection control signals to gears (28) of the vehicle, the GSM (26) configured to select one gear of the gears (28) based on the control inputs, the ECU (34) configured to modify the gear selection control signals based on a control command from an autonomy stack;
a stop terminal (36) for connecting to a stop input; and
a plurality of circuits configured to:
connect the CAN bus (30) to the ECU and the ECU (34) to the GSM (26) when the stop input is disengaged; and
connect the CAN bus (30) to the GSM (26) and bypass the ECU (34) when the stop input is engaged.

2. The printed circuit board (32) of Claim 1, wherein the plurality of terminals comprise:
a first CAN terminal (40) for connecting to the CAN bus (30);
a second CAN terminal (42) for connecting to the GSM (26);
a first ECU terminal (44) for connecting to a first terminal (46) of the ECU (34); and
a second ECU terminal (48) for connecting to a second terminal (50) of the ECU.

3. The printed circuit board (32), of Claim 2, wherein the plurality of circuits are configured to:
connect the first CAN terminal (40) with the first ECU terminal (44) and to connect the second CAN terminal (42) with the second ECU terminal (48) when the stop input is disengaged; and
connect the first CAN terminal (40) with the second CAN terminal (42) when the stop input is engaged.

4. The printed circuit board (32) of Claim 2 or Claim 3, wherein the plurality of circuits comprises a first switching integrated circuit (70_1) and a second integrated circuit (70_2), wherein:
when the stop input is disengaged, the first switching integrated circuit (70_1) is configured to transfer a signal between the first CAN terminal (40) and the first ECU terminal (44), and
when the stop input is disengaged, the second switching integrated circuit (70_2) is configured to transfer a signal between the second CAN terminal (42) and the second ECU terminal (48).

5. The printed circuit board (32) of Claim 4, wherein:
when the stop input is engaged, the first switching integrated circuit (70_1) and the second switching integrated circuit (70_2) are configured to transfer a signal between the first CAN terminal (40) and the second CAN terminal (42).

6. The printed circuit board (70_1) of Claims 4 or 5, further comprising a plurality of transducers (68) configured to convert between analogue signals associated with the CAN bus (30), the GSM (26), and the ECU (34), and digital signals associated with the first (70_1) and second (70_2) integrated circuits.

7. The printed circuit board (32) of Claim 6, wherein the plurality of transducers (68) includes:
a first transducer (68_1) connected between the first CAN terminal (40) and the first integrated circuit (70_1);
a second transducer (68_2) connected between the first integrated circuit (70_1) and the first ECU terminal (44);
a third transducer (68_3) connected between the second CAN terminal (42) and the second integrated circuit (70_2); and
a fourth transducer (68_4) connected between the second integrated circuit (70_2) and the second ECU terminal (48).

8. The printed circuit board (32) of any preceding claim, further comprising:
a first power supply circuit (72) comprising a step-down converter to step down a voltage of a signal associated with the stop input to a voltage of a signal associated with powering the integrated circuits (70); and
a second power supply circuit (74) comprising one or more step-down converters to step down the voltage of the signal associated with the stop input to a voltage for switching the first (70_1) and second (70_2) switching integrated circuits.

9. The printed circuit board (32) of Claim 8, further comprising a relay (76) configured to switch between the first power support circuit (72) and the second power supply circuit (74) in response to the stop input being engaged.

10. A vehicle comprising:
a printed circuit board (32) according to any preceding claim;
the stop input;
the CAN (30);
the GSM (26);
the ECU (34);
the autonomy stack; and
the gears (28).

11. A method of managing a connection between a controller area network, CAN, bus (30) and a gear shifting module, GSM (26), in a vehicle operable in an autonomous mode and a non-autonomous mode, the method comprising:
providing (1002) the printed circuit board (32) of any of Claims 1 to 9;
connecting (1004) the CAN bus (30) to the ECU (34) and the ECU (34) to the GSM (26) when the stop input is disengaged;
modifying (1006), by the ECU (34), the gear selection control signal from the CAN bus (30) based on the control command from an autonomy stack; and
connecting (1008) the CAN bus (30) to the GSM (26) and bypassing the ECU (34) when the stop input is engaged.

## Patentansprüche

1. Leiterplatte (32), die Folgendes umfasst:
eine Vielzahl von Anschlüssen zum Verbinden mit einem Controller Area Network- bzw. CAN-Bus (30) eines Fahrzeugs, einem Gangschaltmodul, GSM (26), und einer elektronischen Steuereinheit, ECU (34), wobei der CAN-Bus (30) dazu ausgelegt ist, Benutzersteuereingaben von einer oder mehreren Steuerschnittstellen des Fahrzeugs zu empfangen und Gangwahlsteuersignale an Gänge (28) des Fahrzeugs zu senden, wobei das GSM (26) dazu ausgelegt ist, einen Gang der Gänge (28) basierend auf den Steuereingaben auszuwählen, wobei die ECU (34) dazu ausgelegt ist, die Gangwahlsteuersignale basierend auf einem Steuerbefehl von einem Autonomiestapel zu modifizieren;
einen Stoppanschluss (36) zum Verbinden mit einem Stoppeingang; und
eine Vielzahl von Schaltungen, die zu Folgendem ausgelegt sind:
Verbinden des CAN-Busses (30) mit der ECU und der ECU (34) mit dem GSM (26), wenn der Stoppeingang deaktiviert ist; und
Verbinden des CAN-Busses (30) mit dem GSM (26) und Umgehen der ECU (34), wenn der Stoppeingang aktiviert ist.

2. Leiterplatte (32) nach Anspruch 1, wobei die Vielzahl von Anschlüssen Folgendes umfasst:
einen ersten CAN-Anschluss (40) zum Verbinden mit dem CAN-Bus (30);
einen zweiten CAN-Anschluss (42) zum Verbinden mit dem GSM (26);
einen ersten ECU-Anschluss (44) zum Verbinden mit einem ersten Anschluss (46) der ECU (34); und
einen zweiten ECU-Anschluss (48) zum Verbinden mit einem zweiten Anschluss (50) der ECU.

3. Leiterplatte (32) nach Anspruch 2, wobei die Vielzahl von Schaltungen zu Folgendem ausgelegt ist:
Verbinden des ersten CAN-Anschlusses (40) mit dem ersten ECU-Anschluss (44) und Verbinden des zweiten CAN-Anschlusses (42) mit dem zweiten ECU-Anschluss (48), wenn der Stoppeingang deaktiviert ist; und
Verbinden des ersten CAN-Anschlusses (40) mit dem zweiten CAN-Anschluss (42), wenn der Stoppeingang aktiviert ist.

4. Leiterplatte (32) nach Anspruch 2 oder Anspruch 3, wobei die Vielzahl von Schaltungen eine erste integrierte Schaltschaltung (70_1) und eine zweite integrierte Schaltung (70_2) umfasst, wobei:
wenn der Stoppeingang deaktiviert ist, die erste integrierte Schaltschaltung (70_1) dazu ausgelegt ist, ein Signal zwischen dem ersten CAN-Anschluss (40) und dem ersten ECU-Anschluss (44) zu übertragen, und
wenn der Stoppeingang deaktiviert ist, die zweite integrierte Schaltschaltung (70_2) dazu ausgelegt ist, ein Signal zwischen dem zweiten CAN-Anschluss (42) und dem zweiten ECU-Anschluss (48) zu übertragen.

5. Leiterplatte (32) nach Anspruch 4, wobei:
wenn der Stoppeingang aktiviert ist, die erste integrierte Schaltschaltung (70_1) und die zweite integrierte Schaltschaltung (70_2) dazu ausgelegt sind, ein Signal zwischen dem ersten CAN-Anschluss (40) und dem zweiten CAN-Anschluss (42) zu übertragen.

6. Leiterplatte (70_1) nach Anspruch 4 oder 5, die ferner eine Vielzahl von Wandlern (68) umfasst, die dazu ausgelegt sind, zwischen analogen Signalen, die mit dem CAN-Bus (30), dem GSM (26) und der ECU (34) assoziiert sind, und digitalen Signalen, die mit der ersten (70_1) und der zweiten (70_2) integrierten Schaltung assoziiert sind, umzuwandeln.

7. Leiterplatte (32) nach Anspruch 6, wobei die Vielzahl von Wandlern (68) Folgendes beinhaltet:
einen ersten Wandler (68_1), der zwischen dem ersten CAN-Anschluss (40) und der ersten integrierten Schaltung (70_1) verbunden ist;
einen zweiten Wandler (68_2), der zwischen der ersten integrierten Schaltung (70_1) und dem ersten ECU-Anschluss (44) verbunden ist;
einen dritten Wandler (68_3), der zwischen dem zweiten CAN-Anschluss (42) und der zweiten integrierten Schaltung (70_2) verbunden ist; und
einen vierten Wandler (68_4), der zwischen der zweiten integrierten Schaltung (70_2) und dem zweiten ECU-Anschluss (48) verbunden ist.

8. Leiterplatte (32) nach einem der vorhergehenden Ansprüche, die ferner Folgendes umfasst:
eine erste Leistungsversorgungsschaltung (72), die einen Abwärtswandler umfasst, um eine Spannung eines Signals, das mit dem Stoppeingang assoziiert ist, auf eine Spannung eines Signals, das mit dem Versorgen der integrierten Schaltungen (70) mit Leistung assoziiert ist, herabzusetzen; und
eine zweite Leistungsversorgungsschaltung (74), die einen oder mehrere Abwärtswandler umfasst, um die Spannung des Signals, das mit dem Stoppeingang assoziiert ist, auf eine Spannung zum Schalten der ersten (70_1) und zweiten (70_2) integrierten Schaltschaltung herabzusetzen.

9. Leiterplatte (32) nach Anspruch 8, die ferner ein Relais (76) umfasst, das dazu ausgelegt ist, als Reaktion darauf, dass der Stoppeingang aktiviert wird, zwischen der ersten Leistungsunterstützungsschaltung (72) und der zweiten Leistungsversorgungsschaltung (74) umzuschalten.

10. Fahrzeug, das Folgendes umfasst:
eine Leiterplatte (32) nach einem der vorhergehenden Ansprüche;
den Stoppeingang;
das CAN (30);
das GSM (26);
die ECU (34);
den Autonomiestapel; und
die Gänge (28).

11. Verfahren zum Verwalten einer Verbindung zwischen einem Controller Area Network- bzw. CAN-Bus (30) und einem Gangschaltmodul, GSM (26), in einem Fahrzeug, das in einem autonomen Modus und einem nicht-autonomen Modus betreibbar ist, wobei das Verfahren Folgendes umfasst:
Bereitstellen (1002) der Leiterplatte (32) nach einem der Ansprüche 1 bis 9;
Verbinden (1004) des CAN-Busses (30) mit der ECU (34) und der ECU (34) mit dem GSM (26), wenn der Stoppeingang deaktiviert ist;
Modifizieren (1006), durch die ECU (34), des Gangwahlsteuersignals von dem CAN-Bus (30) basierend auf dem Steuerbefehl von einem Autonomiestapel; und
Verbinden (1008) des CAN-Busses (30) mit dem GSM (26) und Umgehen der ECU (34), wenn der Stoppeingang aktiviert ist.

## Revendications

1. Carte de circuit imprimé (32) comprenant :
une pluralité de bornes de connexion à un bus de type Controller Area Network, CAN, (30) d'un véhicule, un module de changement de vitesse, GSM (26), et une unité de commande électronique, ECU (34), le bus CAN (30) étant configuré pour recevoir des entrées de commande utilisateur en provenance d'une ou plusieurs interfaces de commande du véhicule et pour envoyer des signaux de commande de sélection de vitesse à des engrenages (28) du véhicule, le GSM (26) étant configuré pour sélectionner un engrenage parmi les engrenages (28) sur la base des entrées de commande, l'ECU (34) étant configuré pour modifier les signaux de commande de sélection de vitesse sur la base d'une commande de contrôle provenant d'une pile d'autonomie ;
une borne d'arrêt (36) pour la connexion à une entrée d'arrêt ; et
une pluralité de circuits configurés pour :
connecter le bus CAN (30) à l'ECU et l'ECU (34) au GSM (26) lorsque l'entrée d'arrêt est désengagée ; et
connecter le bus CAN (30) au GSM (26) et contourner l'ECU (34) lorsque l'entrée d'arrêt est engagée.

2. Carte de circuit imprimé (32) selon la revendication 1, la pluralité de bornes comprenant :
une première borne CAN (40) pour une connexion au bus CAN (30) ;
une deuxième borne CAN (42) pour une connexion au GSM (26) ;
une première borne ECU (44) pour une connexion à une première borne (46) de l'ECU (34) ; et
une deuxième borne ECU (48) pour la connexion à une deuxième borne (50) de l'ECU.

3. Carte de circuit imprimé (32), selon la revendication 2, la pluralité de circuits étant configurés pour :
connecter la première borne CAN (40) à la première borne ECU (44) et connecter la deuxième borne CAN (42) à la deuxième borne ECU (48) lorsque l'entrée d'arrêt est désengagée ; et
connecter la première borne CAN (40) à la deuxième borne CAN (42) lorsque l'entrée d'arrêt est engagée.

4. Carte de circuit imprimé (32) selon la revendication 2 ou la revendication 3, la pluralité de circuits comprenant un premier circuit intégré (70_1) de commutation et un deuxième circuit intégré (70_2),
lorsque l'entrée d'arrêt est désengagée, le premier circuit intégré (70_1) de commutation étant configuré pour transférer un signal entre la première borne CAN (40) et la première borne ECU (44), et
lorsque l'entrée d'arrêt est désengagée, le deuxième circuit intégré (70_2) de commutation étant configuré pour transférer un signal entre la deuxième borne CAN (42) et la deuxième borne ECU (48).

5. Carte de circuit imprimé (32) selon la revendication 4,
lorsque l'entrée d'arrêt est engagée, le premier circuit intégré (70_1) de commutation et le deuxième circuit intégré (70_2) de commutation étant configurés pour transférer un signal entre la première borne CAN (40) et la deuxième borne CAN (42).

6. Carte de circuit imprimé (70_1) selon la revendication 4 ou 5, comprenant en outre une pluralité de transducteurs (68) configurés pour effectuer une conversion entre des signaux analogiques associés au bus CAN (30), au GSM (26) et à l'ECU (34), et des signaux numériques associés aux premier (70_1) et deuxième (70_2) circuits intégrés.

7. Carte de circuit imprimé (32) selon la revendication 6, la pluralité de transducteurs (68) comportant :
un premier transducteur (68_1) connecté entre la première borne CAN (40) et le premier circuit intégré (70_1) ;
un deuxième transducteur (68_2) connecté entre le premier circuit intégré (70_1) et la première borne ECU (44) ;
un troisième transducteur (68_3) connecté entre la deuxième borne CAN (42) et le deuxième circuit intégré (70_2) ; et
un quatrième transducteur (68_4) connecté entre le deuxième circuit intégré (70_2) et la deuxième borne ECU (48).

8. Carte de circuit imprimé (32) selon l'une quelconque des revendications précédentes, comprenant en outre :
un premier circuit d'alimentation (72) comprenant un convertisseur abaisseur pour abaisser une tension d'un signal associé à l'entrée d'arrêt à une tension d'un signal associé à l'alimentation des circuits intégrés (70) ; et
un deuxième circuit d'alimentation (74) comprenant un ou plusieurs convertisseurs abaisseurs pour abaisser la tension du signal associé à l'entrée d'arrêt à une tension pour commuter les premier (70_1) et deuxième (70_2) circuits intégrés de commutation.

9. Carte de circuit imprimé (32) selon la revendication 8, comprenant en outre un relais (76) configuré pour commuter entre le premier circuit de support d'alimentation (72) et le deuxième circuit d'alimentation (74) en réponse au fait que l'entrée d'arrêt est engagée.

10. Véhicule comprenant :
une carte de circuit imprimé (32) selon l'une quelconque des revendications précédentes ;
l'entrée d'arrêt ;
le CAN (30) ;
le GSM (26) ;
l'ECU (34) ;
la pile d'autonomie ; et
les engrenages (28).

11. Procédé de gestion d'une connexion entre un bus de type Controller Area Network, CAN (30) et un module de changement de vitesse, GSM (26), dans un véhicule fonctionnant dans un mode autonome et un mode non autonome, le procédé comprenant :
la fourniture (1002) de la carte de circuit imprimé (32) selon l'une quelconque des revendications 1 à 9 ;
la connexion (1004) du bus CAN (30) à l'ECU (34) et de l'ECU (34) au GSM (26) lorsque l'entrée d'arrêt est désengagée ;
la modification (1006), par l'ECU (34), du signal de commande de sélection de vitesse provenant du bus CAN (30) sur la base de la commande de contrôle provenant d'une pile d'autonomie ; et
la connexion (1008) du bus CAN (30) au GSM (26) et le contournement de l'ECU (34) lorsque l'entrée d'arrêt est engagée.
